# DEMANDE DE BREVET EUROPEEN

(11) **EP 1 909 386 A1**
(43) Date de publication de la demande: **09.04.2008**
(21) Numéro de dépôt: 07392005.0
(22) Date de dépôt: 16.08.2007
(51) Int. Cl.: H03B 5/12, H03H 11/10

(54) **Circuit de capacité négative pour applications hautes fréquences**

(30) Priorité: 17.08.2006 FR 0607343
(71) Demandeur: STMicroelectronics SA, 92120 Montrouge (FR)
(72) Inventeur: Cathelin, Andreia, 38190 Laval (FR); Razafimandimby, Stephane, 38000 Grenoble (FR); Tilhac, Cyrille, 38000 Grenoble (FR)
(74) Mandataire: Schuffenecker, Thierry

(57) **Abrégé**

Un circuit de capacité négative comportant :
- une première branche connectée entre un premier potentiel de référence (Vdd) et un second potentiel de référence (masse), la première branche comportant, en série, une première résistance de polarisation (41), une première diode (42), le collecteur et ensuite l'émetteur d'un premier transistor bipolaire (43) et une première source de courant (44) ;
- une seconde branche connectée entre le premier potentiel de référence (Vdd) et le second potentiel de référence (masse), la seconde branche comportant, en série, une seconde résistance de polarisation (46), une seconde diode (47), le collecteur et ensuite l'émetteur d'un second transistor bipolaire (48) et une seconde source de courant (49) ;
- la base du premier transistor (43) étant connectée au collecteur du second transistor (48) et à une entrée In-, la base de ce second transistor (48) étant connectée au collecteur dudit premier transistor (43) et à une entrée ln⁺;
- une capacité C connectée entre l'émetteur du premier transistor bipolaire (43) et l'émetteur du second transistor bipolaire (48) ;
- et une résistance de linéarisation Rlin 50 connectée en parallèle entre les deux électrodes d'émetteur du premier et du second transistor bipolaire.

## Description

### Domaine technique de l'invention

La présente invention concerne le domaine des circuits électroniques et notamment un circuit à capacité négative.

### Etat de la technique

Les circuits permettant de réaliser un modèle équivalent à celui d'une capacité négative sont des circuits actifs ayant fait l'objet de quelques publications.

Le document *"*Using a negative capacitance to increase the tuning range of a varactor diode in MMIC technology", Svilen Kolev, IEEE Transactions on microwave theory and techniques december 2001 décrit une première application d'un tel circuit.

Un autre article *"*Generation of negative capacitance in a common gate MESFET stage and application to optical receiver design at microwave frequencies", Jason D Drew, Wideband circuits, modelind and techniques, IEE colloquium, may 1996, décrit une autre application d'un tel circuit.

En revanche, on observe que l'on ne dispose pas de circuits de ce type pour des applications hautes fréquences, fonctionnant notamment à des fréquences de 2GHz ou plus en technologie BiCMOS.

Or il est un intérêt de pouvoir utiliser ce type de circuit dans des applications de filtrage en téléphonie mobile.

### Exposé de l'invention

La présente invention a pour but de proposer un circuit de capacité négative pour des applications haute fréquence.

Un autre but de la présente invention consiste à proposer un circuit de capacité négative facile à réaliser et susceptible de servir pour la réalisation d'un circuit de filtrage en téléphonie mobile.

C'est un autre but de la présente invention que de réaliser un circuit de capacité négative pouvant être facilement combiné avec des circuits de filtrages comportant des résonateurs BAW.
L'invention réalise ces buts au moyen d'un circuit de capacité négative comportant :
- une première branche connectée entre un premier potentiel de référence (Vdd) et un second potentiel de référence (masse), la première branche comportant, en série, une première résistance de polarisation, une première diode, le collecteur et ensuite l'émetteur d'un premier transistor bipolaire et une première source de courant ;
- une seconde branche connectée entre le premier potentiel de référence (Vdd) et le second potentiel de référence (masse), la seconde branche comportant, en série, une seconde résistance de polarisation, une seconde diode, le collecteur et ensuite l'émetteur d'un second transistor bipolaire et une seconde source de courant ;
- la base du premier transistor étant connectée au collecteur du second transistor et à une entrée In-, la base de ce second transistor étant connectée au collecteur dudit premier transistor et à une entrée In+ ;
- une capacité C connectée entre l'émetteur du premier transistor bipolaire et l'émetteur du second transistor bipolaire;
- et une résistance de linéarisation Rlin connectée en parallèle entre les deux électrodes d'émetteur du premier et du second transistor bipolaire.

On réalise ainsi un circuit électronique ayant un comportant électrique qui est celui d'une capacité négative et ce même pour des fréquences élevées.

Dans un mode de réalisation particulier, les sources de courant sont réalisées au moyen de transistors de type MOS.

De préférence, les premières et secondes diodes sont réalisées au moyen de jonction émetteur-collecteur de transistors bipolaires.

Le circuit de capacité négative se prête à une grande variété d'applications.

Dans un mode de réalisation particulier, le circuit de capacité négative est intégré dans un circuit de filtrage comportant un résonateur acoustique, par exemple de type BAW, afin de permettre l'éloignement des fréquences de résonance et d'anti-résonance de ce résonateur. En venant ajouter un élément capacitif variable, tel qu'un varactor par exemple, on obtient alors une cellule de filtrage accordable extrêmement performante.

Alternativement, le circuit de capacité négative peut être intégré dans un oscillateur commandé en tension - ou Voltage Controlled Oscillator (V.C.O.) ou tout autre circuit électronique dans lequel on pourra venir ajuster précisément une capacité.

### Description des dessins

D'autres caractéristiques, buts et avantages de l'invention apparaîtront à la lecture de la description et des dessins ci-après, donnés uniquement à titre d'exemples non limitatifs. Sur les dessins annexés :
La figure 1 illustre le modèle électrique de principe d'un circuit à capacité négative conforme à la présente invention.
La figure 2 illustre les courbes représentatives d'impédance du circuit à capacité négative de la figure 1.
La figure 3 illustre les équations de fonctionnement du circuit de la figure 1.
La figure 4 représente un mode de réalisation préféré d'un circuit à capacité négative conforme à la présente invention.
La figure 5 illustre les courbes représentatives du circuit de la figure 4..
La figure 6 illustre, à des fins de comparaison, les courbes d'impédance du circuit de la figure 4 par rapport à une capacité classique positive.
La figure 7 illustre, à des fins de comparaison, les courbes d'impédance et de gain du circuit de la figure 4 par rapport à une inductance.
Les figures 8a, 8b, et 8c illustrent respectivement le modèle électrique et les courbes caractéristiques d'un résonateur de type BAW pouvant être associé au circuit de capacité négative selon la présente invention.
La figure 9A illustre la combinaison d'un résonateur BAW sur lequel on vient connecter en parallèle le circuit de capacité négative conforme à la présente invention.
Les figures 9B et 9C illustrent respectivement l'effet de la capacité négative sur la fréquence d'anti-résonance du résonateur BAW de la figure 9A en fonction de l'écart entre la valeur absolue de Cneg et C0 + Cm.
La figure 10A illustre une autre application du circuit de capacité négative que l'on vient combiner avec un oscillateur BAW et un varactor afin de réaliser un filtre ajustable.
Les figures 10B à 10D illustrent respectivement les courbes caractéristiques du circuit de la figure 10A en fonction de la valeur de la capacité négative Cneg par rapport aux valeurs C0 + Cm et C0 + Cm + Cv.
La figure 11 illustre un circuit oscillant commandé en tension *(Voltage Controlled Oscillator)* réalisé au moyen d'un circuit de capacité négative selon la présente invention.

### Description d'un mode de réalisation préféré

On décrira à présent plus particulièrement un mode de réalisation d'un circuit comportant un résonateur intégré conforme à la présente invention et adapté à la réalisation d'un circuit de réception d'un signal RF utilisable notamment en téléphonie mobile. Plus spécifiquement, le circuit sera associé avec un résonateur acoustique, tel que par exemple un résonateur BAW *(Bulk Acoustic Wave)* ou SAW *(Solidly Acoustic Wave)* permettant la réalisation de circuits de filtrage extrêmement performants.

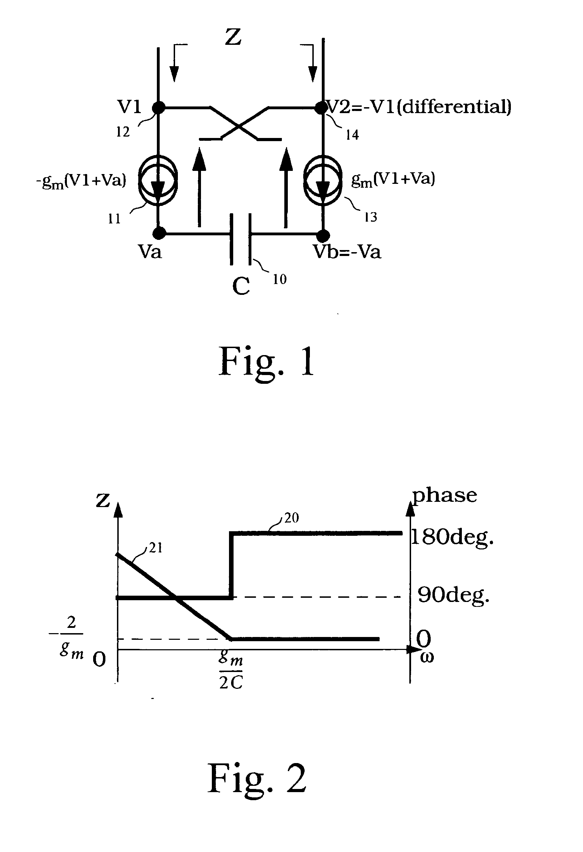

En référence à la figure 1, on décrit à présent la réalisation d'un circuit de capacité négative entre deux électrodes respectivement 12 et 14, lequel comporte, en série, une première source de courant commandée 11, une capacité 10 et une seconde source de courant commandée 13.

L'on désigne par V1 le potentiel de l'électrode 12 et par V2 (supposé égal à -V1 dans un mode différentiel) celui de l'électrode 14. Par ailleurs, on désigne par Va le potentiel de l'électrode de jonction entre la première source 11 et la capacité 10 et Vb le potentiel de l'électrode de jonction entre la seconde source 13 et la capacité 10.

Les équations de fonctionnement des deux sources de courant commandées 11 et 13 sont les suivantes :
I = gm (V2 + Vb) = - gm (V1 + Va) pour la source de courant commandée 11 et
I = gm (V1 + Va) pour la source de courant commandée 13.

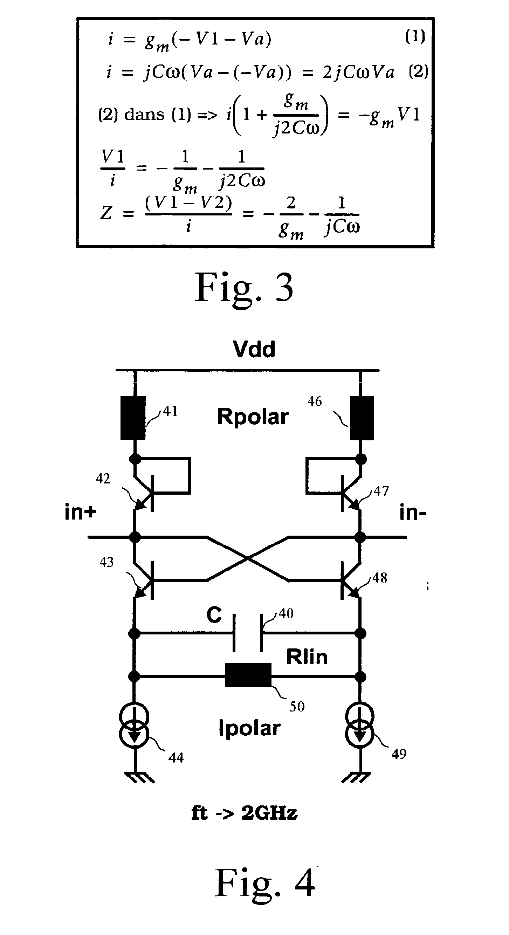

Le paramètre gm est par définition la transconductance, source de courant commandée en tension des transistors bipolaires 43 et 48 (dans la figure 4).

En mettant en oeuvre ce modèle électrique, dont les équations sont rappelées à des fins pédagogiques dans la figure 3, on constate que l'on parvient à réaliser des courbes d'impédance conformes à celles illustrées en figure 2. Comme on le voit, la courbe d'impédance 21 chute de -20dB / decade jusqu'à une pulsation critique égale à gm/2C et, à partir de cette même pulsation, le circuit provoque une avance de phase de 90 degrés sur la courbe de phase 20.

Ces courbes mettent donc en évidence un comportement d'un circuit résistif avec une capacité négative.

La figure 4 illustre un mode de réalisation préféré d'un circuit conforme à la présente invention adapté à un fonctionnement en haute fréquence.

Ce circuit comporte une première et une seconde branches connectées chacune entre un premier potentiel de référence Vdd et un second potentiel de référence (la masse).

La première branche comporte, en série, une première résistance de polarisation 41, une première diode 42, le collecteur et ensuite l'émetteur d'un premier transistor bipolaire 43 et une première source de courant 44.

La second branche comporte, en série, une seconde résistance de polarisation 46, une seconde diode 47, le collecteur et ensuite l'émetteur d'un second transistor bipolaire 48 et une seconde source de courant 49.

La base du premier transistor 43 est connectée au collecteur du second transistor 48 (correspondant par ailleurs à l'entrée In-). De manière différentielle, la base de ce second transistor 48 est connectée au collecteur du premier transistor 43 (correspondant à l'entrée In+).

Enfin, le circuit comporte une capacité C 40 connectée entre l'émetteur du premier transistor bipolaire 43 et l'émetteur du second transistor bipolaire 48. Une résistance de linéarisation Rlin 50 est également connectée en parallèle entre les deux électrodes d'émetteur du premier et du second transistor bipolaire.

On utilise de manière avantageuse des transistors bipolaires pour les circuits 43 et 44 en raison de la valeur élevée du rapport transconductance/courant qu'ils apportent.

Les sources de courant 44 et 49 sont des sources de polarisation coopérant respectivement avec les résistances de polarisation 41 et 46, respectivement.

Dans un mode de réalisation préféré, les diodes 42 et 47 sont réalisées au moyen de la jonction émetteur -collecteur de transistors bipolaires.

Dans un premier mode de réalisation, ces sources de courant 44 et 49 sont réalisées au moyen de transistors de type MOS. Alternativement, on pourra les réaliser au moyen de transistors de type bipolaire.

On note que le circuit de la figure 4 tend à osciller si l'on n'impose pas une commande en tension aux bornes des électrodes de collecteur des premier et second transistor bipolaires 43 et 44, formant par ailleurs les deux électrodes d'entrée In- et In+.

En revanche, si l'on commande en tension les deux entrées In+ et In-respectivement connectées au collecteurs des transistors 43 et 48, l'on évite le fonctionnement naturellement oscillatoire de ce circuit. On simule alors un comportement qui est conforme à celui décrit en relation avec la figure 1 et particulièrement adapté pour des applications haute fréquences et notamment supérieures à 2GHz. La résistance de linéarisation 50 permet d'assurer un fonctionnement du circuit pour des excursions importantes de tension d'entrée de l'ordre de 150 millivolts.

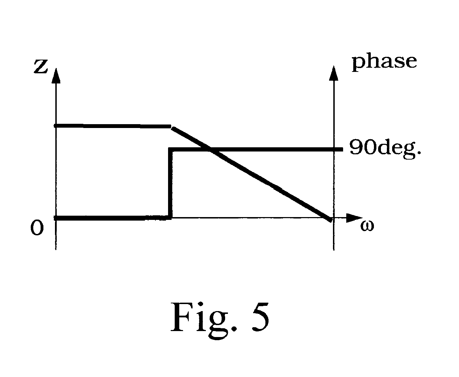

La figure 5 montre les courbes représentatives de l'impédance (module de l'amplitude et de la phase) du circuit de la figure 4. On constate que l'on a légèrement modifiée la courbe de la figure 2 en venant insérer la résistance de linéarisation 50 en parallèle avec la capacité 40 et les transistors montés en diode.

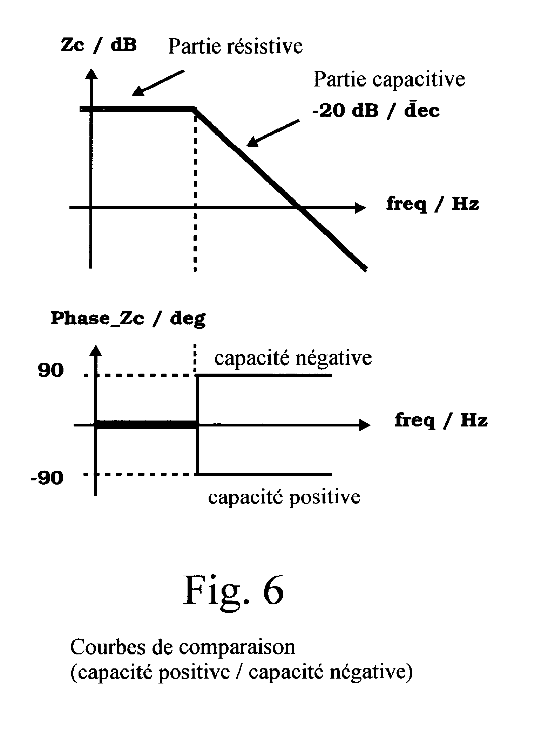

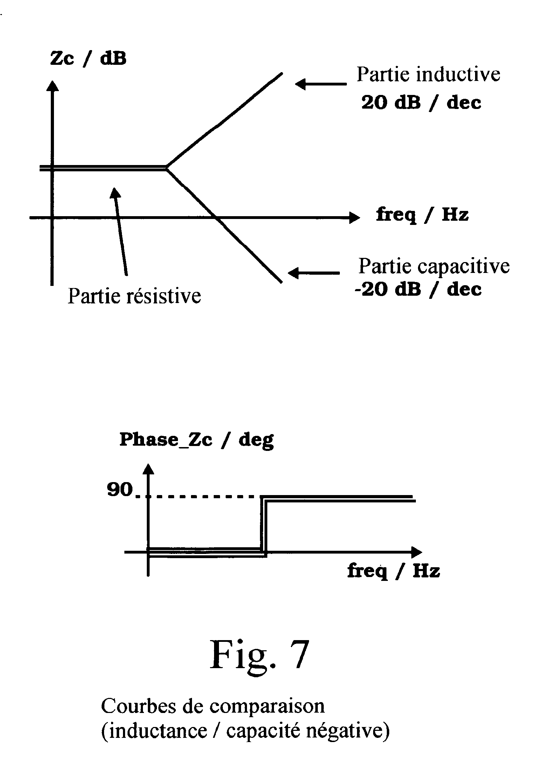

Les figures 6 et 7 illustrent le fonctionnement du circuit de la figure 4, par rapport à celui d'une capacité positive (figure 6) et d'une inductance (figure 7).

Comme on le voit dans la figure 6, on observe bien une courbe d'impédance décroissante de pente -20dB par décade à partir d'une fréquence de coupure. S'agissant de la courbe de gain, on observe en revanche une avance de phase de 90 degrés à partir de la fréquence de coupure, contrairement au retard de phase de 90 degrés que l'on observerait pour un modèle purement capacitif.

On a donc bien réalisé un circuit présentant un comportement de capacité négative.

La figure 7 rappelle les courbes caractéristiques pour une inductance qui, elle, présente également une avance de phase de 90 degrés à partir de la fréquence de coupure. En revanche, pour l'inductance, la courbe d'impédance tend à croître à partir de cette même fréquence de coupure, contrairement à la courbe représentative de la capacité négative.

Le circuit de la présente invention est susceptible de permettre de nombreuses applications et notamment en hautes fréquences.

On décrit à présent, de manière nullement limitative, l'intégration de ce circuit avec un résonateur de type BAW de manière à réaliser un circuit de filtrage accordable. Plus spécifiquement, on vient connecter le circuit de capacité négative sur les bornes d'un résonateur BAW de manière à venir agir sur la fréquence d'anti-résonance de ce résonateur.

On décrira à présent plus particulièrement un mode de réalisation d'un circuit comportant un résonateur intégré conforme à la présente invention et adapté à la réalisation d'un circuit de réception d'un signal RF utilisable notamment en téléphonie mobile. En effet, en téléphonie mobile, et notamment dans les applications les plus récentes telles que le *Wide Code Division Multiplexing Access* (WCDMA), on rencontre la nécessité d'opérer un filtrage particulièrement performant. Il est à noter qu'il ne s'agit là que d'un exemple non limitatif d'utilisation du nouveau composant acoustique intégrable dont on va à présent exposer les caractéristiques.

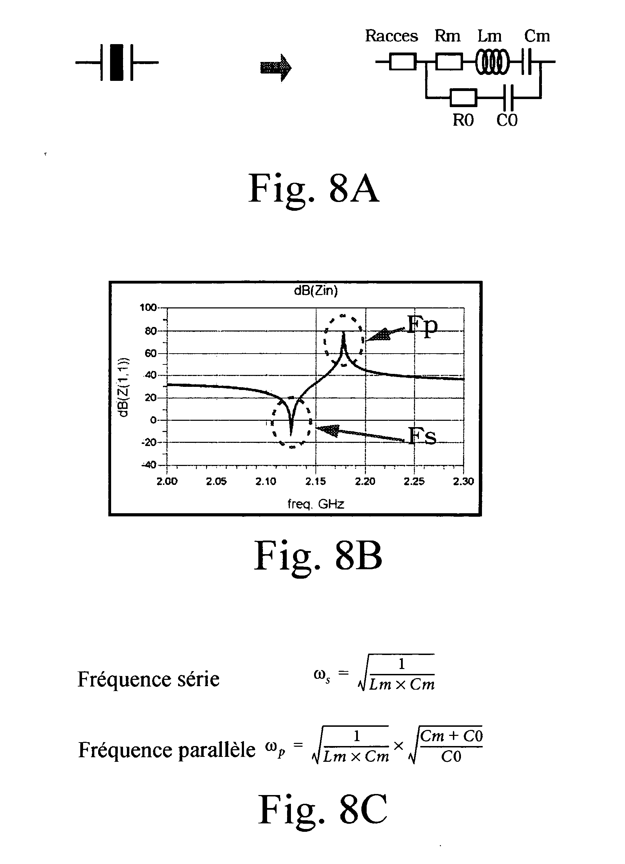

L'invention permet de réaliser ce filtrage d'une manière particulièrement efficace et complètement intégrée et ce en venant combiner le circuit de capacité négative avec un résonateur BAW dont on rappellera, comme cela est illustré dans les figures 8A, 8B et 8C le modèle électrique équivalent, les courbes d'impédance et de phase ainsi que les équations des fréquences de résonance série et parallèle.

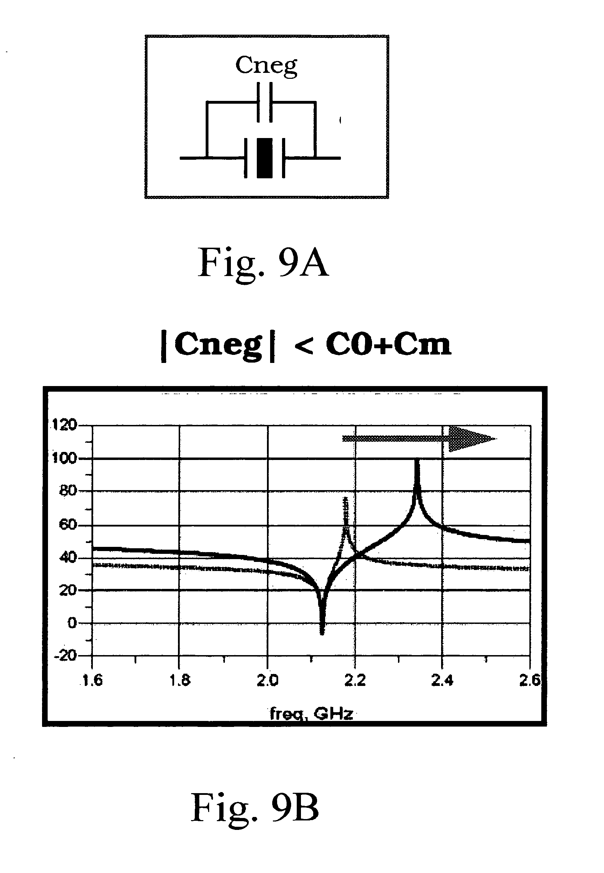

La figure 9A illustre une première application du circuit de capacité négative selon l'invention, dans laquelle on vient connecter ce circuit en parallèle sur un résonateur BAW.

Une telle combinaison permet, de manière surprenante et extrêmement avantageuse, de venir jouer sur la fréquence d'anti-résonance fp de manière à éloigner cette dernière de la fréquence série pour bénéficier pleinement des fonctionnalités offertes par cette fréquence de résonance série. De cette manière on arrive même à se passer d'un quelconque inductance dont l'utilisation s'avère particulièrement coûteuse en terme de surface d'occupation sur un substrat de silicium et qui, de surcroît, fait apparaître des fréquences d'anti-résonance parasites à basse fréquence et, enfin, dégrade considérablement le coefficient de qualité du filtre acoustique constitué par le résonateur BAW.

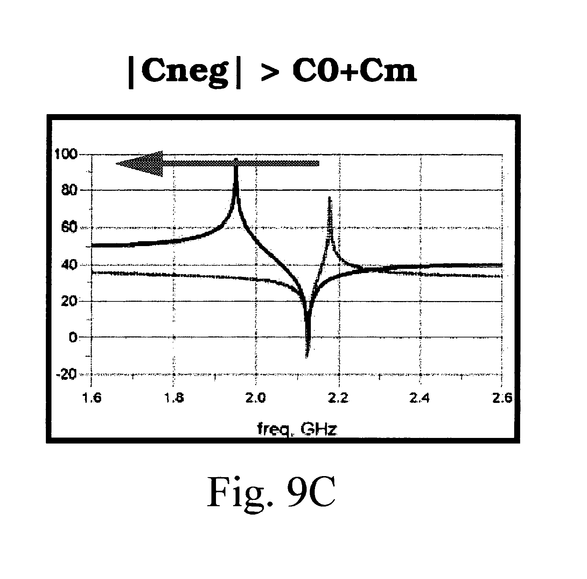

Les figures 9B et 9C montrent que, en fonction de la valeur absolue de cette capacité négative, on peut venir déplacer, soit à droite, soit à gauche, la fréquence d'anti-résonance Fp tout en maintenant inchangée la fréquence de résonance série.

Plus particulièrement, la figure 9B montre que lorsque la valeur absolue de Cneg est inférieure aux paramètres internes C0 + Cm du résonateur BAW, la fréquence d'anti-résonance se déplace vers la droite.

Cette même fréquence d'anti-résonance se déplace vers la gauche comme illustré dans la figure 9C lorsque, au contraire la valeur absolue de Cneg est supérieure à C0 + Cm.

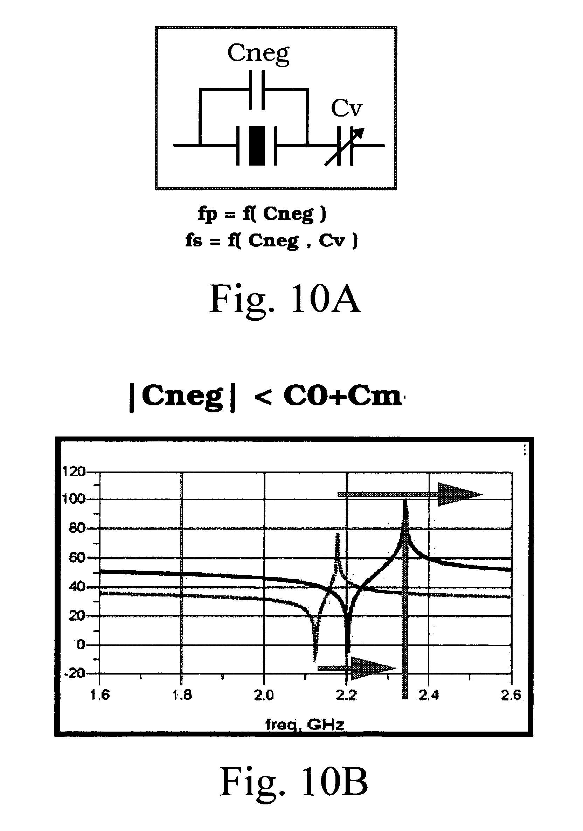

La figure 10A illustre un second mode de réalisation d'un circuit résonateur accordable utilisant un circuit de capacité négative conforme à la présente invention. Ce second mode de réalisation comporte, en série avec le circuit de la figure 9A, un composant capacitif réglable, tel qu'un varactor par exemple, présentant une capacité réglable Cv.

On obtient ainsi un circuit susceptible d'offrir de multiples possibilités d'accord en fonction de la valeur absolue de Cneg.

Les figures 10B à 10D illustrent respectivement les courbes caractéristiques du second mode de fonctionnement en fonction de la valeur de la capacité négative Cneg par rapport aux valeurs C0 + Cm, et C0 + Cm + Cv.

Lorsque la valeur absolue de Cneg est inférieure à C0 + Cm, alors on observe un décalage vers la droite des deux fréquences de résonance série et parallèle, comme illustré dans la figure 10B.

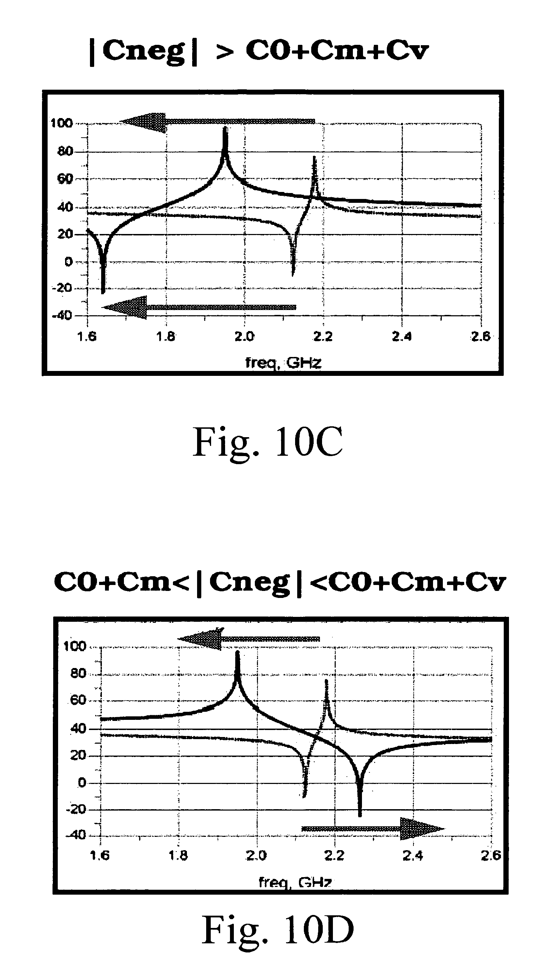

Lorsque la valeur absolue de Cneg est supérieure à C0 + Cm + Cv alors on observe un décalage vers la gauche des deux fréquences de résonance série Fs et parallèle Fp, comme illustré dans la figure 10C.

Enfin, lorsque la valeur absolue de Cneg est comprise entre CO+Cm et CO+CM+Cv, on observe que la fréquence série se décale vers la droite tandis que la fréquence parallèle se décale vers la gauche, comme illustré dans la figure 10D.

Comme on le voit, en fonction des valeurs particulières que l'on donnera aux paramètres Cneg et Cv, on peut ainsi réaliser une vaste possibilités d'accord pour le circuit de résonance de la présente invention.

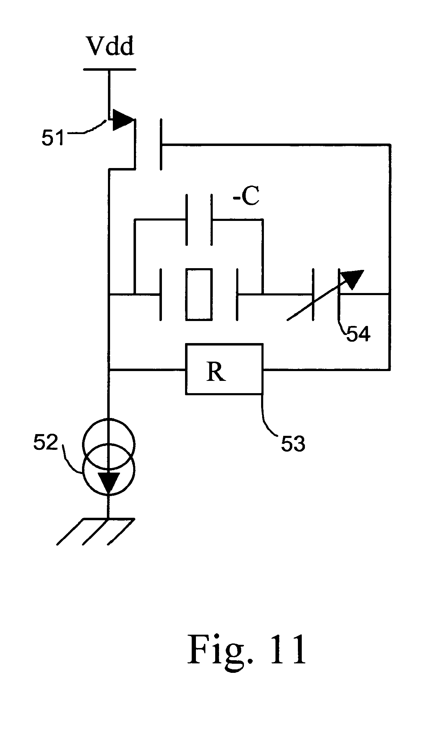

Dans un autre mode d'application tel que représenté dans la figure 11, en associant la cellule de la figure 10A selon la présente invention, à un circuit de compensation de pertes basé sur un transistor PMOS 51 connecté en série avec une source de courant 52 ainsi qu'avec une résistance 53, un VCO réglable au moyen de la commande sur la capacité variable est réalisé,. La capacité variable - représenté par l'élément 54 - sera, cette fois-ci, préférentiellement de type matrice de capacité interconnectable pour exploiter une grande plage de variation. Elle sera commandée par un mot binaire et permettra de couvrir la bande de fréquence comprise entre la fréquence de résonance nominale i.e. pour la valeur maximale de la capacité variable et la fréquence parallèle définie alors par la valeur résultante de la différence entre Co et Cneg.

Comme on le voit dans la figure 11, l'oscillateur commandé en tension est basé sur une implémentation de type oscillateur Pierce polarisé par :
- la source de courant de polarisation 52
- et la résistance R 53 connectant le drain du transistor PMOS 54 à sa grille.

La taille du transistor définit le niveau de compensation de perte requis pour entretenir l'oscillation.

## Revendications

1. Un circuit de capacité négative comportant une première (In+) et une seconde entrée (In-), comportant :
- une première branche connectée entre un premier potentiel de référence (Vdd) et un second potentiel de référence (masse), ladite première branche comportant, en série, une première résistance de polarisation (41), une première diode (42), le collecteur et ensuite l'émetteur d'un premier transistor bipolaire (43) et une première source de courant (44) ;
- une seconde branche connectée entre ledit premier potentiel de référence (Vdd) et ledit second potentiel de référence (masse), ladite seconde branche comportant, en série, une seconde résistance de polarisation (46), une seconde diode (47), le collecteur et ensuite l'é metteurd'un second transistor bipolaire (48) et une seconde source de courant (49) ;
- la base dudit premier transistor (43) étant connectée au collecteur dudit second transistor (48) et à ladite seconde entrée (In-), la base de ce second transistor (48) étant connectée au collecteur dudit premier transistor (43) et à ladite première entrée (In+) ;
- une capacité C 40 connectée entre l'émetteur du premier transistor bipolaire (43) et l'émetteur du second transistor bipolaire (48) ;
- et une résistance de linéarisation Rlin 50 connectée en parallèle entre les deux électrodes d'émetteur du premier et du second transistor bipolaire.

2. Circuit selon la revendication 1 **caractérisé en ce que** lesdites sources de courant sont réalisées au moyen de transistors de type MOS.

3. Circuit selon la revendication 1 **caractérisé en ce que** lesdites premières et secondes diodes (42,47) sont réalisées au moyen de la jonction émetteur-collecteur de transistors bipolaires.

4. Circuit selon l'une des revendications précédentes **caractérisé en ce qu'**il est connecté en parallèle sur un résonateur BAW de manière à venir agir sur la fréquence d'anti-résonance de ce résonateur.

5. Circuit selon la revendication 4 **caractérisé en ce qu'**il comporte un varactor permettant de venir agir sur la fréquence de résonance série du résonateur.

6. Circuit selon l'une des revendications 1 à 4 **caractérisé en ce qu'**il est utilisé pour la réalisation d'un oscillateur commandé en tension (V.C.O).
